# EUROPEAN PATENT SPECIFICATION

(11) **EP 3 579 006 B1**
(45) Date of publication and mention of the grant of the patent: **03.05.2023**
(21) Application number: 18176431.7
(22) Date of filing: 07.06.2018
(51) Int. Cl.: G01R 31/36, G01R 31/367, G01R 31/374, G01R 31/382, G01R 31/3842, G01R 31/389, G01R 31/392, G01R 31/387

(54) **VALIDATION OF A TEMPERATURE SENSOR OF A BATTERY CELL**
VALIDIERUNG EINES TEMPERATURSENSORS EINER BATTERIEZELLE
VALIDATION D'UN CAPTEUR DE TEMPÉRATURE D'UNE CELLULE DE BATTERIE

(43) Date of publication of application: 11.12.2019
(73) Proprietor: Samsung SDI Co., Ltd., Gyeonggi-do 17084 (KR)
(72) Inventor: Schiffer, Adrian, 1050 Wien (AT); Parz, Peter, 8111 Gratwein (AT)
(74) Representative: Gulde & Partner

(56) References cited:
- EP-A1- 3 121 613
- EP-A2- 2 720 055
- CN-U- 204 030 697
- US-A1- 2007 001 679
- US-A1- 2008 234 956
- US-A1- 2011 172 939
- US-A1- 2012 265 462
- US-A1- 2013 080 096
- US-A1- 2014 139 149
- ABLAY GUNYAZ: "An observer-based fault diagnosis in battery systems of hybrid vehicles", 2013 8TH INTERNATIONAL CONFERENCE ON ELECTRICAL AND ELECTRONICS ENGINEERING (ELECO), THE CHAMBER OF TURKISH ELECTRICAL ENGINEERS-BURSA, 28 November 2013 (2013-11-28), pages 238-242, XP032551727, DOI: 10.1109/ELECO.2013.6713839 [retrieved on 2014-01-15]
- XIONG RUI ET AL: "Review on sensors fault diagnosis and fault-tolerant techniques for lithium ion batteries in electric vehicles", 2018 13TH IEEE CONFERENCE ON INDUSTRIAL ELECTRONICS AND APPLICATIONS (ICIEA), IEEE, 31 May 2018 (2018-05-31), pages 406-410, XP033366500, DOI: 10.1109/ICIEA.2018.8397751 [retrieved on 2018-06-26]
- EL MEJDOUBI ASMAE ET AL: "State-of-Charge and State-of-Health Lithium-Ion Batteries' Diagnosis According to Surface Temperature Variation", IEEE TRANSACTIONS ON INDUSTRIAL ELECTRONICS, IEEE SERVICE CENTER, PISCATAWAY, NJ, USA, vol. 63, no. 4, 1 April 2016 (2016-04-01), pages 2391-2402, XP011602224, ISSN: 0278-0046, DOI: 10.1109/TIE.2015.2509916 [retrieved on 2016-03-08]
- MOSHIRVAZIRI ANDISHE ET AL: "Modelling of temperature dependent impedance in lithium ion polymer batteries and impact analysis on electric vehicles", IECON 2014 - 40TH ANNUAL CONFERENCE OF THE IEEE INDUSTRIAL ELECTRONICS SOCIETY, IEEE, 29 October 2014 (2014-10-29), pages 3149-3155, XP032739661, DOI: 10.1109/IECON.2014.7048960 [retrieved on 2015-02-24]
- HURIA T ET AL: "High fidelity electrical model with thermal dependence for characterization and simulation of high power lithium battery cells", ELECTRIC VEHICLE CONFERENCE (IEVC), 2012 IEEE INTERNATIONAL, IEEE, 4 March 2012 (2012-03-04), pages 1-8, XP032203010, DOI: 10.1109/IEVC.2012.6183271 ISBN: 978-1-4673-1562-3

## Description

### Field of the Invention

The present invention relates to a method for validating a temperature sensor integrated into a battery system, particularly for validating a temperature measurement of that temperature sensor. The present invention further relates to a battery system comprising at least one battery cell, a temperature sensor in thermal contact with the battery cell and a control unit that is configured for performing the validation method of the present invention.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like. In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

For meeting the dynamic power demands of various electrical consumers connected to the battery system, static control of battery power output and charging is not sufficient. Thus, steady exchange of information between the battery system and the controllers of the electrical consumers is required. This information includes the battery system's actual state of charge (SOC), potential electrical performance, charging ability and internal resistance as well as actual or predicted power demands or surpluses of the consumers. Battery systems usually comprise a battery management system (BMS) for processing this information.

The BMS is usually coupled to the controller of one or more electrical consumers as well as to each of the battery modules of the battery system. For controlling a plurality of battery modules by a single BMS a daisy chain setup may be used. In such setup, the BMS, as master, is connected for communication in series to a plurality of battery modules, particularly to a plurality of cell supervision circuits, CSC, of the respective battery modules. Therein, the CSC may be arranged on a printed circuit board, PCB, on top of a respective battery module.

Within the battery modules or the battery system, a plurality of sensors is utilized for determining the information on the battery cells therein. Usually at least voltage sensors, current sensors, and temperature sensors are installed in the battery modules or system. However, due to restriction of the installation space, the number of sensors that can be utilized is limited, particularly in smaller battery modules or systems. At the same time, the impact or the risk of a faulty measurement due to a malfunctioning sensor increases as the number of a certain sensor species decreases. Until now, a minimum amount of each sensor species has thus to be installed even into small systems. Then a validation of the individual sensors can be achieved by cross comparison of their respective measurement results.

According to the prior art, a further reduction of the number of sensors, particularly temperature sensors, in a battery system is limited. Disadvantageously this puts additional constraints on the available construction space and keeps production costs high.

ABLAY GUNYAZ: "An observer-based fault diagnosis in battery systems of hybrid vehicles", 2013 8TH INTERNATIONAL CONFERENCE ON ELECTRICAL AND ELECTRONICS ENGINEERING (ELECO), THE CHAMBER OF TURKISH ELECTRICAL ENGINEERS-BURSA, 28 November 2013 (2013-11-28), pages 238-242, XP032551727, DOI: 10.1109/ELEC0.2013.6713839 discloses a method for diagnosing possible sensor faults in a battery system, using a model/observer-based fault diagnosis approach for a Ni-MH battery system of a HEV. US 2014/139149 A1 discloses a method for converting values of a standardized power output of a battery at 25°C/50% SOC to values of power output that are present at another temperature and at another SOC. XIONG RUI ET AL: "Review on sensors fault diagnosis and fault-tolerant techniques for lithium ion batteries in electric vehicles", 2018 13TH IEEE CONFERENCE ON INDUSTRIAL ELECTRONICS AND APPLICATIONS (ICIEA), IEEE, 31 May 2018 (2018-05-31), pages 406-410, XP033366500, DOI: 10.1109/ICIEA.2018.8397751 discloses a comprehensive review of techniques for sensors fault diagnosis and tolerance for lithium ion batteries in EVs from the perspectives of model-based approaches. Further prior art related to temperature dependent states of battery cells can be found in EL MEJDOUBI ASMAE ET AL: "State-of-Charge and State-of-Health Lithium-Ion Batteries' Diagnosis According to Surface Temperature Variation", IEEE TRANSACTIONS ON INDUSTRIAL ELECTRONICS, IEEE SERVICE CENTER, PISCATAWAY, NJ, USA, vol. 63, no. 4, 1 April 2016 (2016-04-01), pages 2391-2402, XPO1 1 602224, SSN: 0278-0046, DOI: 10.1109/TIE.2015.2509916, in MOSHIRVAZIRI ANDISHE ET AL: "Modelling of temperature dependent impedance in lithium ion polymer batteries and impact analysis on electric vehicles", IECON 2014- 40TH ANNUAL CONFERENCE OF THE IEEE INDUSTRIAL ELECTRONICS SOCIETY, IEEE, 29 October 2014 (2014-10-29), pages 3149-3155, XP032739661, DOI: 10.1109/IECON.2014.7048960, in US 2008/234956 A1, in EP 2720055 A2, in US 2007/001679 A1, in US 2011/172939 A1, in US 2013/080096 A1, in EP 3121613 A1, in US 2012/265462 A1, and in CN 204030697 U.

It is thus an object of the present invention to overcome or reduce at least some of the drawbacks of the prior art and to provide method for validating a temperature sensor integrated into a battery system that allows for a further reduction of the amount of sensors.

### Description of the invention

One or more of the drawbacks of the prior art could be avoided or at least reduced by means of the present invention, according to which a method for validating a temperature sensor, particularly for validating a measurement of a temperature sensor, as defined in claim 1 is provided. In the method of the present invention, an internal resistance as well as a state of charge, SOC, of at least one battery cell, which is in thermal contact with a temperature sensor to be validated, is determined. The internal resistance R_{I} and the SOC are key performance indicators for battery cells that are commonly determined in many available battery systems and various methods for determining the internal resistance, R_{I}, and the state of charge, SOC, of a battery cell are known to the person skilled in the art.

According to the method of the present invention, at least one reference temperature is determined from a lookup table, LUT, or a functional relationship, which are connecting at least the internal resistance, the SOC, and the temperature of a reference battery cell, and preferably connect the internal resistance, the SOC, the temperature, and the current height of a reference battery cell. In other words, the LUT or functional relationship provide a function T= f(SOC, R_{I}), preferably T= f(SOC, R_{I}, I), for the reference battery cell. Preferably, the LUT or functional relationship connects each pair of values for the internal resistance and the state of charge to exactly one value of a temperature of the reference battery cell. However, the LUT could also map a plurality of values for SOC and/or R_{I} to the same temperature value of a reference battery cell, i.e. provide different classes of temperatures for the reference battery cell. Further preferred, values for the SOC and the R_{I} are determined for a plurality of battery cells in thermal contact with the temperature sensor and a plurality of reference temperatures, one for each cell, is determined from the LUT or functional relationship. Particularly preferred, the reference battery cell is of the same type as the at least one battery cell in thermal contact with the temperature sensor to be validated.

In the method of the invention, the at least one reference temperature is finally compared with a temperature measurement of the temperature sensor to be validated. Based on the result of this comparison, the temperature sensor or the temperature measurement of the temperature sensor can be validated. The method of the present invention thus advantageously allows validating even a single temperature sensor by utilizing the characteristic values of SOC and internal resistance, and preferably also the current height, that are already obtained in many battery systems. This is enabled by the inventive use of the LUT or functional relationship linking the values of the SOC and internal resistance of a battery cell to the temperature of a reference battery cell. Thus, a reference temperature for the battery cell is derived from the values of SOC and internal resistance.

According to the present invention, the LUT is determined in a test stand during development of the battery cells. Particularly, the LUT is based on a plurality of reference measurements of an internal resistance of the reference cell that are obtained at a plurality of different temperatures of the reference battery cell and for a plurality of different SOC values of the reference battery cell. For determining the SOC and the internal resistance of the reference battery cell any method known to the person skilled in the art can be used. Exemplarily, the methods mentioned below can be used. The LUT is then stored as a data field on a suitable data structure, e.g. in the CSC/BMS of one or more battery modules/systems with battery cells corresponding to the reference battery cell.

Further, the functional relationship is based on an equivalent circuit model of the at least one battery cell. An example of such an equivalent circuit model is described in Huria T et al., High Fidelity Electrical Model with Thermal Dependence for Characterization and Simulation of High Power Lithium Battery Cells, 978-1-4673-1561-6, 2012*.*

A set of equations and/or a parametrized function, which are connecting the SOC, the internal resistance, and the temperature of the at least one battery cell are derived from such equivalent circuit model. Therein, the set of equations and/or the parametrized function define the battery cell's internal resistance as a function of its SOC and temperature or vice versa, i.e. provide at least one of the functional relationships R_{I}=f(SOC, T), T=f(SOC, R_{I}), and SOC=f(R_{I}, T), and preferably at least one of the functional relationships R_{I}=f(SOC, T, I), T=f(SOC, R_{I}, I), and SOC=f(R_{I}, T, I).

During development of the at least one battery cell or a battery module or battery system with such cell, the parameters of the parametrized function are fitted to the plurality of reference measurements as described above. Additionally, each of the aforementioned functions may further depend on one or more further characteristic values of a battery cell. Then, the respective function may also be fitted to a reference battery cell based on measurements of this one or more further characteristic values during development or testing. Preferably, in a control unit performing the inventive method either an LUT, i.e. an extensive data field, or a parametrized function with fitted parameters is stored and utilized for determining the temperature of the at least one battery cell based on a determined SOC and internal resistance with minimal computational effort.

Also in determining the LUT an equivalent circuit model of the reference battery cell is combined with a plurality of reference measurements of an internal resistance of the reference battery cell, which are obtained at a plurality of different temperatures and for a plurality of different SOC values of the reference battery cell. Therein, the parameters of the parametrized function are determined (fitted) by fitting the parametrized function to the values obtained by such a plurality of reference measurements. The LUT is determined based on the parametrized function with fitted parameters. Advantageously, the number of required reference measurements can thus be minimized. Special care has to be taken, that all specific characteristics of the used electrochemical energy storage device are represented in the LUT. By combining an equivalent circuit model and a plurality of reference measurements a continuous LUT or a functional relationship (parametrized function with fitted parameters) can be determined connecting a reference temperature to any combination of SOC and internal resistance of a battery cell. In the context of the present invention, the functional relationship refers to a fitted parametrized function connecting a reference temperature to any combination of SOC and internal resistance of a battery cell. Hence, a control unit performing the method of the invention must not necessarily contain a vast amount of data triples (T, SOC, R_{I}) but may solely contain such functional relationship for deriving one value of such data triple based on the knowledge of the remaining two values.

In a preferred embodiment of the method of the present invention, a difference between the at least one reference temperature and the temperature measurement of the temperature sensor is determined. Preferably, differences between each of a plurality of reference temperatures, each obtained for one of a plurality of battery cells in thermal contact with the temperature sensor, and a temperature measurement of the temperature sensor are determined. Also preferred, multiple temperature measurements are utilized for comparison with one or more reference temperatures, in the form of individual values or of mean values.

The thus obtained one or more (temperature) differences, i.e. ΔT, are compared to a preconfigured threshold and the at least one battery cell is validated based on whether the obtained one or more (temperature) differences exceeds the preconfigured threshold. Particularly, if the temperature difference(s) is/are to be smaller than the preconfigured threshold, the temperature sensor is determined to function correctly and if the temperature difference(s) exceed(s) the preconfigured threshold the temperature sensor is determined to function incorrectly. Further preferred, a control signal is outputted if the temperature difference exceeds the preconfigured threshold. Particularly preferred, the control signal is outputted from a control unit, e.g. of a battery system, performing the method of the invention.

Preferably, the control signal is further processed in the control unit of a battery system comprising the battery cell or of a load apparatus connected to the battery system. Particularly preferred, in response to the control signal a notification to a user is outputted, e.g. via a graphical user interface, GUI, or other human machine interface, HMI, of e.g. the battery system or load apparatus. Also preferred, in response to the control signal, a flag is set in a data structure marking the validated temperature sensor to be functional or non-functional. No further measures as described before may be initiated if the flag is set only sporadically.

In a preferred embodiment of the present invention, the steps of determining the internal resistance, of determining the state of charge of the at least one battery cell and the temperature measurement of the temperature sensor are all performed during a preconfigured period of time. Thus, the comparability of the temperature measurement and the reference temperature obtained by the LUT or functional relationship is advantageously increased. Particularly preferred, the preconfigured period of time is less than 30 s, less than 15 s, less than 10 s, less than 5 s, or less than 1 s.

The comparability of reference temperature(s) and temperature measurement(s) is further increased by improving the thermal contact between the temperature sensor and the at least one battery cell. Various methods for increasing thermal contact, e.g. by ensuring sufficient mechanical contact with a spring loaded measuring head or using heat-conducting paste, are known to the person skilled in the art. Further preferred, reference temperatures obtained from the LUT or functional relationship using the SOC and the internal resistance of a specific battery cell are used only for validation of temperature sensor(s) that is (are) intended for performing temperature measurements of that specific battery cell.

In the context of the present invention, the internal resistance of a battery cell refers to the resistance of a virtual impedance which is considered to be connected in series with an ideal voltage source in an equivalent circuit model of the battery cell. The internal resistance of the at least one battery cell can be determined using any method known to the skilled person. Preferably, the internal resistance of at least one battery cell is determined by measuring a voltage drop of the battery cell during a charging or discharge pulse of the battery cell. While the battery cell delivers a current to a load, i.e. during a discharge pulse, or while a current is provided to the battery cell, i.e. during a charging pulse, a measured voltage output of the battery cell is less than the open-circuit voltage, OCV, of the battery cell. As this voltage drop is the product of internal resistance and the drawn or provided current, the internal resistance can be calculated using the known value of the drawn or provided current. In order to disregard the actual drop of the OCV due to discharge or charge of the battery cell, preferably a short discharge pulse or charge pulse < 30 s, preferably < 20 s, further preferred < 10 s, particularly preferred < 5 s and also preferred < 1 s, is used. Alternatively, the voltage drop of the battery cell is measured during a balancing current is drawn from or provided to the battery cell. Advantageously, such balancing current is usually a well defined current.

In a particularly preferred embodiment of the method of the invention, the voltage drop is measured with respect to an actual terminal voltage of the at least one battery cell and in response to a specific load current drawn from the at least one battery cell. Therein, an actual terminal voltage is determined by initially measuring the cell's open-circuit voltage at the beginning of the step of determining the internal resistance of the at least one battery cell.

Further, a well defined load current is drawn from the at least one battery cell or the drawn load current is measured using at least one current sensor, e.g. a shunt resistor with well-defined ohmic resistance. As the load current is drawn, the voltage drop is determined as the step response of the battery's terminal voltage with respect to the initially measured open circuit voltage. Alternatively, the voltage drop over a load with well defined ohmic resistance is used for determining the internal resistance of a battery cell using the OCV of the cell.

According to another preferred embodiment, the internal resistance of at least one battery cell is determined by measuring a voltage transient in response to cutting a specific load from the at least one battery cell. Due to the discharge of the battery cell in response to the load current, the battery cell's voltage will return to another OCV than the initially measured OCV. The voltage transient is thus determined as the step response of the voltage after cutting the load. Therein, in a graph of the voltage over time, the step response refers to an essential vertical portion of the graph. In other words, the voltage transient is the absolute value of the voltage difference between (i) the terminal voltage just before the load was cut and (ii) the terminal voltage at which the rate of change of the voltage can again be resolved.

In the context of the present invention, the state of charge, SOC, refers to the actual charging state of a battery cell relative to the battery's maximal capacity. Various methods for determining a battery cell's state of charge are known to the person skilled in the art and, in principal, each of these methods can be employed in the method of the invention. Therein, the measurement method may depend on the actual battery type, e.g. whether the cell is a lithium ion, Li-ion, battery cell or a nickel-metal hydride, NiMH, battery cell. The SOC of the at least one battery cell is preferably determined based on at least one of: coulomb counting (current integration method), a voltage based method, impedance spectroscopy, chemical methods (e.g. hydrometer based methods), pressure-based methods (only for NiMH batteries), Kalman filtering, or by a combination of the aforementioned methods.

In a particularly preferred embodiment of the invention, the SOC of the at least one battery cell is determined based on measuring an actual terminal voltage of the at least one battery cell. Particularly preferred, the deterioration of the terminal voltage in dependence of the state of charge is known for the at least one battery cell. Thus, from a measurement of the actual terminal voltage the SOC can be derived via a SOC-LUT or a SOC functional relationship that connect an actual terminal voltage to a SOC value. Preferably, a SOC-LUT is utilized for determining a reference SOC based on a measurement of the actual terminal voltage.

The SOC-LUT or SOC functional relationship is preferably obtained from a plurality of reference measurements of a reference battery cell of the same type as the at least one battery cell and/or an equivalent circuit model of the at least one battery cell. In the reference measurements the terminal voltage is measured for a plurality of known SOCs, wherein the SOC of the reference cell may be determined by any of the methods mentioned above. The reference measurements may be combined with an equivalent circuit model of the at least one battery cell providing one or more equations or a parametrized function relating the SOC of the battery cell to its actual terminal voltage. Therein, the equations may be solved numerically and/or the parameters of the function may be fitted based on the reference measurements. Particularly preferred, in a control unit performing the method of the invention either a SOC-LUT or a parametrized function with fitted parameters is stored and utilized for determining SOC from the actual terminal voltage with low computational effort. Further preferred, in this embodiment the measurement of an actual terminal voltage is advantageously utilized for determining the SOC and the internal resistance of the cell.

Another aspect of the present invention relates to a battery system as described in claim 10 that comprises at least one battery cell and at least one temperature sensor which is in thermal contact with the at least one battery cell. The battery system further comprises at least one voltage sensor for measuring a terminal voltage of the at least one battery cell and a control unit that is configured for performing the method of the present invention as described in claims 1-9. According to a preferred embodiment, the temperature sensor comprises a thermistor, e.g. a negative temperature coefficient, NTC, which is in thermal contact with the battery cell of the battery module. However, any other kind of temperature sensor that preferably outputs the temperature measurement as electronic signal can be used as well. Further preferred, the voltage sensor may be a Hall probe, another suitable voltage sensor or measurement circuit.

Preferably, the control unit is configured for receiving temperature measurements from the at least one temperature sensor and terminal voltage measurements of the at least one voltage sensor. Further preferred, the control unit is configured for determining the SOC and the internal resistance of the at least one battery cell utilizing the received voltage measurements. Therefore, the control unit preferably comprises a memory storing a SOC-LUT that is relating the SOC of a reference battery cell to its actual terminal voltage. Further, the control unit is preferably configured for drawing a well defined load current from the battery cell, for providing a well defined charging current to the battery cell or for drawing/providing a well defined balancing current from/to the battery cell, for measuring a voltage drop of the terminal voltage of the cell during the load current, charging current or balancing current is drawn or provided, and for calculating an internal resistance from the load, charging, or balancing current and the terminal voltage drop. The control unit also comprises a memory storing a LUT relating the SOC and the internal resistance of the at least one battery cell with the actual temperature of a reference battery cell and is further configured for determining a reference temperature for the at least one battery cell utilizing the SOC and internal resistance of the at least one battery cell and the LUT. Preferably, a characteristic current (within some margin) is used for the resistance determination. The current height should be predefined, depending on the application area of the monitored battery.

According to a particularly preferred embodiment, the battery system comprises at least one battery module with a plurality of aligned battery cells connected in series and/or in parallel between module terminals of the battery module. At least one temperature sensor is in thermal contact with at least one battery cell of the battery module. Further, at least one voltage sensor is configured for measuring a terminal voltage of a battery cell of the battery module and at least one current sensor is configured for measuring a load current of this battery cell of the battery module. Further preferred, the control unit comprises at least one cell supervision circuit, CSC, that is connected to one of the at least one battery module. Particularly preferred, the CSC is disposed on a (flexible) PCB that is mechanically connected to the battery module, e.g. to a top surface or a side surface of the battery module. The CSC is preferably configured for receiving measurement values of the sensors, i.e. of the at least one temperature sensor, at least one voltage sensor, and at least one current sensor of that battery module that is connected to the CSC. At least some of the sensors or sensor components may be formed as a part of the CSC and/or disposed on the (flexible) PCB.

Further preferred, the control unit of the battery system also comprises a battery management system, BMS, which is connected to at least one CSC. Preferably, the battery system comprises a plurality of battery modules, a plurality of CSCs connected thereto, and a BMS connected to the plurality of CSCs. The BMS may be connected to the plurality of CSCs in a daisy chain configuration or via a suitable communication bus, such as e.g. a CAN bus. The BMS may be further configured for communication with the CSCs as well as with electrical consumers located outside the battery system and connected to the battery system.

According to this embodiment, the BMS is preferably configured for receiving voltage measurement, current measurement, and temperature measurement values from the at least one connected CSC. Based on these received measurement values, the BMS preferably determines SOC and internal resistance of at least one battery cell of the battery module connected to the at least one CSC from which at least the voltage and current values originate. Therefore, the BMS preferably comprises and utilizes a memory storing a SOC-LUT relating the SOC of a reference battery cell to its actual terminal voltage. Further preferred, the BMS is configured for calculating an internal resistance from the received current and voltage measurements. The BMS is also configured for determining at least one reference temperature based on the determined SOC and internal resistance of the at least one battery cell. Therefore the BMS preferably comprises a memory storing a LUT relating the determined SOC and internal resistance with the temperature of a reference battery cell.

The BMS is finally configured for comparing the determined at least one reference temperature to the at least one received temperature value and for outputting a control signal based on whether or not a difference between the at least one measured temperature and the at least one determined reference temperature exceeds a preconfigured threshold. In this embodiment, the measurement tasks and the computing tasks are distributed in the battery system. Advantageously, storage of the LUTs is only required within the BMS.

The electronic or electric devices and/or any other relevant devices or components according to embodiments of the present invention described herein, except those described explicitly as hardware, may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips.

Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the embodiments of the present invention as defined in the claims.

Further aspects of the present invention are disclosed in the dependent claims or the following description of the drawings. Different embodiments or aspects of the present invention as described herein are advantageously combined if not explicitly stated otherwise.

### Brief Description of the Drawings

Features will become apparent to those of ordinary skill in the art by describing in detail exemplary embodiments with reference to the attached drawings in which:
- Fig. 1: illustrates an equivalent circuit of a battery cell comprising internal resistance R_{I};
- Fig. 2: illustrates the a battery cell's terminal voltage in response to drawing and cutting a load current;
- Fig. 3: illustrates the dependence of a battery cell's internal resistance R_{I} from the battery cell's state of charge, SOC, and the battery cell's temperature; and
- Fig. 4: illustrates the dependence of a battery cell's internal resistance R_{I} from the battery cell's temperature at a fixed state of charge, SOC, of the battery cell.

### Detailed Description of the Figures

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted.

The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art.

Accordingly, processes, elements, and techniques that are not considered necessary to those having ordinary skill in the art for a complete understanding of the aspects and features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

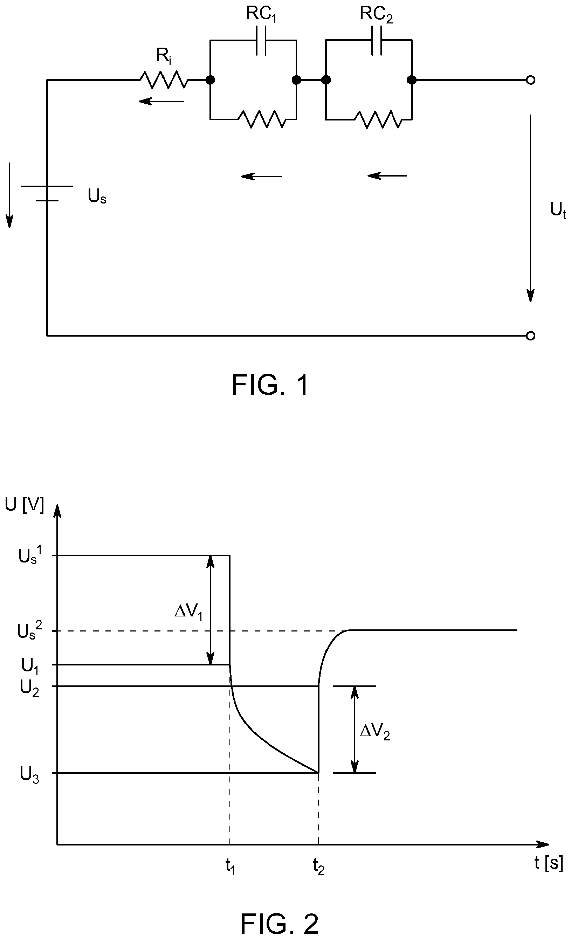

Figure 1 illustrates an equivalent circuit of a battery cell that can be used for deriving an LUT for the method of the present invention. In the equivalent circuit, the battery cell is modelled in first order as a series connection of an ideal voltage source providing the source voltage Us and an internal resistance R_{I}. The equivalent circuit provides a terminal voltage U, between two external terminals of the circuit, e.g. to an external load. Therein, terminal voltage U, can be mapped to a real battery cell's terminal voltage and is smaller than the source voltage U_{S}, at least once a load is connected to the external terminals of the equivalent circuit.

In order to provide a best fitting model, in the equivalent circuit of Figure 1 further RC elements are connected in series to the ideal voltage source and the internal resistance R_{I}. Therein, a first RC element RC₁ comprises a first resistance R₁ connected in parallel with a first capacitance C₁ and a second RC element RC₂ comprises a second resistance R₂ connected in parallel with a second capacitance C₂. The values of the second resistance R₂ and the second capacitance C₂ are smaller than the values of the first resistance R₁ and the first capacitance C₁, respectively. The RC elements RC₁ and RC₂ thus allow for a series expansion of the battery cell's impedance and thus for a best fit of the equivalent circuit to even the non-linear performance characteristics of a real battery cell.

Figure 2 illustrates a time series of the terminal voltage U, of the equivalent circuit of Figure 1. Initially, no load is connected to the external terminals of the equivalent circuit and thus the terminal voltage U, of the equivalent circuit is roughly equal to a first source voltage U_{S}¹ (open circuit voltage) which corresponds to a first state of charge of the battery cell. A more detailed description of the equivalent circuit model of Figure 1 is disclosed in Huria T et al., High Fidelity Electrical Model with Thermal Dependence for Characterization and Simulation of High Power Lithium Battery Cells, 978-1-4673-1561-6, 2012*.*

At a time point t₁ an external load is connected to the external terminals of the circuit of Figure 1. The external load draws a specific load I_{L} current from the battery cell. As illustrated in Figure 2, the terminal voltage Uₜ drops with a step response almost instantaneously before decreasing further at a smaller rate until the time point t₂. Therein, the step response voltage drop ΔV₁ of the terminal voltage is due to the voltage drop over the internal resistance R_{I} due to the load current I_{L}. Hence, by measuring the voltage drop ΔV₁ the value of the internal resistance can be determined using the value of the load current I_{L} via Ohms law as R_{I} = ΔV₁ / I_{L}. The further non-linear decrease of the terminal voltage U, in between the time points t₁ and t₂ is best explained by the behavior of the RC elements RC₁ and RC₂ and can be thus considered to be independent of the internal resistance's magnitude to a large extent.

At a time point t₂, the load is disconnected (cut) from the external terminals of the circuit of Figure 1 and hence the load current I_{L} is suspended. In response thereto, the terminal voltage Uₜ of the battery cell recovers towards the open cell voltage of the battery cell. As the battery experienced an actual discharge due to the integrated drawn load current I_{L}, the terminal voltage settles at a source voltage U_{S}² which is smaller than the initial source voltage U_{S}¹.

Again, the step response of the voltage, this time the step response voltage increase ΔV₂, is due to the internal resistance R_{I}, particularly due to the omitted voltage drop at the internal resistance after the ceasing of the load current I_{L}. Thus, also by measuring the voltage drop ΔV₂ the value of the internal resistance can be determined using the value of the load current I_{L} via Ohms law as R_{I} = ΔV₂ / I_{L}. The further non-linear increase of the terminal voltage U, after time point t₂ is again due to the behavior of the RC elements RC₁ and RC₂ and can be thus considered to be independent of the internal resistance's magnitude to a large extent.

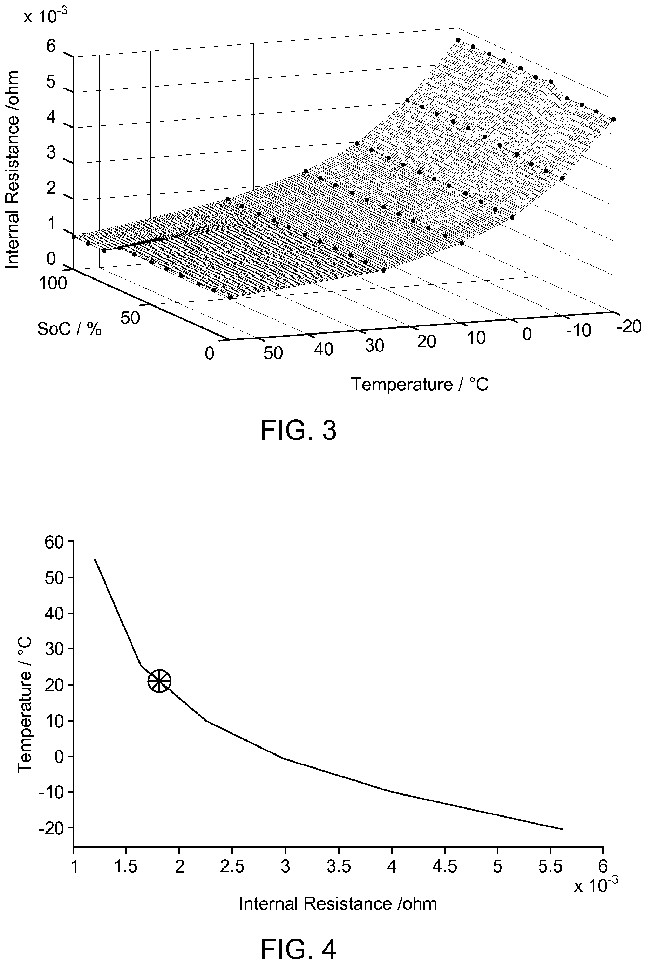

Figure 3 illustrates the dependence of a battery cell's internal resistance R_{I} from the battery cell's state of charge, SOC, and of the battery cell's temperature. Therein, the illustration of Figure 3 can be understood as a visualization or graph of a Lookup table according to the present invention. Particularly, the black dots represent measurement values of a plurality of reference measurements of the battery cell's internal resistance at different temperatures and different SOCs. Particularly, the battery cell's internal resistance was measured at temperatures of -20°C, -10°C, 0°C, 10°C, 25°C, and 60°C and at different states of charge from 0 to 100% in 10% increments. The so obtained reference measurement values of the cell's internal resistance were then fitted to a parametrized function defining the battery cell's internal resistance as a function of its SOC and temperature in order to determine the parameters of that function. The so obtained parametrized function with fitted parameters provides the continuous functional relationship R_{I}=f(SOC,T) as illustrated in Figure 3. This functional relationship assigns a specific value for the battery cell's internal resistance R_{I} to each pair of the battery cell's temperature, T, and state of charge, SOC.

Figure 4 illustrates a cut through the graph in Figure 3 at a state of charge, SOC, of 50%. The so derived line graph illustrates the dependency of a battery cell's internal resistance, R_{I}, from its temperature, T, at a SOC of 50%. Hence, by determining the internal resistance of a battery cell that has been determined to have a SOC of 50%, the temperature of the battery cell can be deduced. Exemplarily, by drawing a well defined load current from a battery cell at a SOC of 50% and by measuring the corresponding voltage step response as illustrated in Figure 2, the battery cell's internal resistance was determined to be around 1.8 mOhm.

Then, by utilizing the section of the LUT as illustrated in Figure 4, the reference temperature of the battery cell is determined to be around 20.5°C. This reference temperature can then be used to validate the temperature measurement of at least one temperature sensor which is in thermal contact with the battery cell. Exemplarily, if a temperature measurement obtained by the temperature sensor (during a preconfigured time period around the measurements of SOC and voltage drop ΔV) lies in between 19°C and 22°C, preferably 19.5°C and 21.5°C, the temperature sensor is validated. If, however, the difference between the temperature measurement and the reference temperature of 20.5°C exceeds a value of e.g. 4-.5 2,5°C, preferably of e.g. 2°C, the temperature sensor is determined to be erroneous or at least the respective temperature measurement is determined to be faulty. The threshold has to be defined, based on the measurement accuracy of the utilized Temperature sensor, the characteristics in the LUT and measurement accuracy of current and voltage used to determine the cell resistance. In response to such determination, the battery cell might be shut down or a notification may be output to a user of the battery cell.

## Claims

1. Method for validating a temperature sensor, comprising the steps of:
determining an internal resistance of at least one battery cell in thermal contact with the temperature sensor;
determining a state of charge, SOC, of the at least one battery cell;
determining at least one reference temperature from a lookup table, LUT, or functional relationship connecting the internal resistance, the SOC, and a temperature of a reference battery cell; and
comparing the at least one reference temperature with at least one temperature measurement of the temperature sensor,
wherein said lookup table, LUT, or said functional relationship connecting the internal resistance, the SOC, and a temperature of a reference battery cell are both obtained according to the following steps:
obtaining a plurality of reference measurements of an internal resistance of said reference battery cell at a plurality of different temperatures and for a plurality of difference SOC values;
combining an equivalent circuit model of the reference battery with said plurality of reference measurements;
deriving from the equivalent circuit model a parametrized function connecting the SOC, the internal resistance and the temperature of the battery cell; and
fitting the parameters of said function to the plurality of reference measurements to obtain a fitted parametrized function connecting the at least one reference temperature to any combination of an SOC and internal resistance of the at least one battery cell thus providing said LUT or said functional relationship.

2. Method of claim 1, further comprising the steps of:
determining a difference between at least one reference temperature and the temperature measurement of the temperature sensor; and
validating the temperature sensor based on whether the difference exceeds a preconfigured threshold.

3. Method of claim 1 or 2, wherein the determination of the internal resistance and state of charge of the at least one battery cell and the at least one temperature measurement of the temperature sensor are performed during a preconfigured period of time.

4. Method according to any one of the preceding claims, wherein the internal resistance of at least one battery cell is determined based on a measurement of a voltage drop during a discharge pulse.

5. Method according to claim 4, wherein the voltage drop is measured with respect to an actual terminal voltage of the at least one battery cell and in response to a specific load or balancing current drawn from the at least one battery cell and/or a specific charging or balancing current provided to the at least one battery cell.

6. Method according to any one of the preceding claims, wherein the internal resistance of at least one battery cell is determined by measuring a voltage transient in response to cutting a specific load from the at least one battery cell.

7. Method according to any one of the preceding claims, wherein the SOC of the at least one battery cell is determined based on measuring an actual terminal voltage of the at least one battery cell.

8. Method according to claim 7, wherein a reference SOC value is determined based on the measured actual terminal voltage and a SOC-Lookup-table, LUT.

9. Method according to any one of the preceding claims, wherein the reference battery cell is of the same type as the at least one battery cell.

10. Battery system, comprising at least one battery cell, at least one temperature sensor in thermal contact with the at least one battery cell, at least one voltage sensor for measuring a terminal voltage of the at least one battery cell, and a control unit configured for performing the method of any one of the claims 1 to 9.

11. Battery system of claim 10, further comprising:
at least one battery module with a plurality of aligned battery cells;
at least one temperature sensor in thermal contact with at least one battery cell of the battery module;
at least one voltage sensor configured for measuring a terminal voltage of a battery cell of the battery module; and
at least one current sensor configured for measuring a load, balancing and/or charging current of the battery cell of the battery module;
wherein the control unit comprises at least one cell supervision circuit, CSC, connected to one of the at least one battery module and configured for receiving measurement values of the sensors of the connected battery module.

12. Battery system of claim 11, wherein the control unit further comprises a battery management system, BMS, connected to at least one CSC, and being configured for:
receiving voltage, current, and temperature values from the at least one CSC,
determining SOC and internal resistance of at least one battery cell of the battery module connected to the at least one CSC,
determining the at least one reference temperature, and comparing it to the at least one temperature value received from the at least one CSC.

## Patentansprüche

1. Verfahren zur Validierung eines Temperatursensors, das die folgenden Schritte umfasst:
Bestimmen eines Innenwiderstands von mindestens einer Batteriezelle, die in thermischem Kontakt mit dem Temperatursensor steht;
Bestimmen eines Ladezustands, SOC, der mindestens einen Batteriezelle;
Bestimmen mindestens einer Referenztemperatur aus einer Nachschlagetabelle, LUT oder funktionalen Beziehung, die den Innenwiderstand, den SOC und eine Temperatur einer Referenzbatteriezelle verbindet; und
Vergleichen der mindestens einen Referenztemperatur mit mindestens einer Temperaturmessung des Temperatursensors,
wobei die besagte Nachschlagetabelle, LUT, oder die besagte funktionale Beziehung, die den Innenwiderstand, den SOC und eine Temperatur einer Referenzbatteriezelle verbindet, beide gemäß den folgenden Schritten erhalten werden:
Erhalten einer Vielzahl von Referenzmessungen eines Innenwiderstands der besagten Referenzbatteriezelle bei einer Vielzahl von unterschiedlichen Temperaturen und für eine Vielzahl von unterschiedlichen SOC-Werten;
Kombinieren eines Ersatzschaltungsmodells der Referenzbatterie mit der besagten Vielzahl von Referenzmessungen;
Ableiten einer parametrisierten Funktion aus dem Ersatzschaltungsmodell, die den SOC, den Innenwiderstand und die Temperatur der Batteriezelle verbindet; und
Anpassen der Parameter der besagten Funktion an die Vielzahl von Referenzmessungen, um eine angepasste parametrisierte Funktion zu erhalten, die die mindestens eine Referenztemperatur mit einer beliebigen Kombination aus einem SOC und einem Innenwiderstand der mindestens einen Batteriezelle verbindet und so die LUT oder die funktionale Beziehung bereitstellt.

2. Verfahren nach Anspruch 1, das außerdem die folgenden Schritte umfasst:
Bestimmen einer Differenz zwischen mindestens einer Referenztemperatur und der Temperaturmessung des Temperatursensors; und
Validieren des Temperatursensors auf der Grundlage, ob die Differenz einen vorkonfigurierten Schwellenwert überschreitet.

3. Verfahren nach Anspruch 1 oder 2, wobei die Bestimmung des Innenwiderstandes und des Ladezustandes der mindestens einen Batteriezelle und die mindestens eine Temperaturmessung des Temperatursensors während einer vorkonfigurierten Zeitspanne durchgeführt werden.

4. Verfahren nach einem der vorhergehenden Ansprüche, wobei der Innenwiderstand mindestens einer Batteriezelle auf der Grundlage einer Messung eines Spannungsabfalls während eines Entladeimpulses bestimmt wird.

5. Verfahren nach Anspruch 4, wobei der Spannungsabfall in Bezug auf eine tatsächliche Anschlussspannung der mindestens einen Batteriezelle und in Reaktion auf einen spezifischen Last- oder Ausgleichsstrom, der der mindestens einen Batteriezelle entnommen wird, und/oder einen spezifischen Lade- oder Ausgleichsstrom, der der mindestens einen Batteriezelle zugeführt wird, gemessen wird.

6. Verfahren nach einem der vorhergehenden Ansprüche, wobei der Innenwiderstand mindestens einer Batteriezelle durch Messung eines Spannungsübergangs als Reaktion auf das Entlasten einer bestimmten Last von der mindestens einen Batteriezelle bestimmt wird.

7. Verfahren nach einem der vorhergehenden Ansprüche, wobei der SOC der mindestens einen Batteriezelle auf der Grundlage der Messung einer tatsächlichen Anschlussspannung der mindestens einen Batteriezelle bestimmt wird.

8. Verfahren nach Anspruch 7, wobei ein SOC-Referenzwert auf der Grundlage der gemessenen tatsächlichen Anschlussspannung und einer SOC-Nachschlagetabelle (LUT) bestimmt wird.

9. Verfahren nach einem der vorhergehenden Ansprüche, wobei die Referenzbatteriezelle vom gleichen Typ ist wie die mindestens eine Batteriezelle.

10. Batteriesystem, umfassend mindestens eine Batteriezelle, mindestens einen Temperatursensor in thermischem Kontakt mit der mindestens einen Batteriezelle, mindestens einen Spannungssensor zum Messen einer Anschlussspannung der mindestens einen Batteriezelle und eine Steuereinheit, die zur Durchführung des Verfahrens nach einem der Ansprüche 1 bis 9 konfiguriert ist.

11. Batteriesystem nach Anspruch 10, das außerdem umfasst:
mindestens ein Batteriemodul mit einer Vielzahl von ausgerichteten Batteriezellen;
mindestens einen Temperatursensor in thermischem Kontakt mit mindestens einer Batteriezelle des Batteriemoduls;
mindestens einen Spannungssensor, der zum Messen einer Anschlussspannung einer Batteriezelle des Batteriemoduls konfiguriert ist; und
mindestens einen Stromsensor, der zum Messen eines Last-, Ausgleichs- und/oder Ladestroms der Batteriezelle des Batteriemoduls konfiguriert ist;
wobei die Steuereinheit mindestens eine Zellenüberwachungsschaltung, CSC, umfasst, die mit einem des mindestens einen Batteriemoduls verbunden und zum Empfangen von Messwerten der Sensoren des verbundenen Batteriemoduls konfiguriert ist.

12. Batteriesystem nach Anspruch 11, wobei die Steuereinheit ferner ein Batteriemanagementsystem (BMS) umfasst, das mit mindestens einer CSC verbunden und konfiguriert ist zum:
Empfangen von Spannungs-, Strom- und Temperaturwerten von der mindestens einen CSC,
Bestimmen des SOC und des Innenwiderstands von mindestens einer Batteriezelle des mit der mindestens einen CSC verbundenen Batteriemoduls,
Bestimmen der mindestens einen Referenztemperatur und deren Vergleich mit dem mindestens einen Temperaturwert, der von der mindestens einen CSC empfangen wurde.

## Revendications

1. Procédé de validation d'un capteur de température, comprenant les étapes consistant à :
déterminer une résistance interne d'au moins un élément de batterie en contact thermique avec le capteur de température ;
déterminer un état de charge, SOC, de l'au moins un élément de batterie ;
déterminer au moins une température de référence à partir d'une table de consultation, LUT, ou d'une relation fonctionnelle connectant la résistance interne, le SOC et une température d'un élément de batterie de référence ; et
comparer l'au moins une température de référence avec au moins une mesure de température du capteur de température,
dans lequel ladite table de consultation, LUT, ou ladite relation fonctionnelle connectant la résistance interne, le SOC et une température d'un élément de batterie de référence sont toutes deux obtenues selon les étapes suivantes consistant à :
obtenir une pluralité de mesures de référence d'une résistance interne dudit élément de batterie de référence à une pluralité de températures différentes et pour une pluralité de valeurs de SOC différentes ;
combiner un modèle de circuit équivalent de la batterie de référence avec ladite pluralité de mesures de référence ;
dériver, à partir du modèle de circuit équivalent, une fonction paramétrée connectant le SOC, la résistance interne et la température de l'élément de batterie ; et
ajuster les paramètres de ladite fonction à la pluralité de mesures de référence pour obtenir une fonction paramétrée ajustée connectant l'au moins une température de référence à toute combinaison d'un SOC et d'une résistance interne de l'au moins un élément de batterie, fournissant ainsi ladite LUT ou ladite relation fonctionnelle.

2. Procédé selon la revendication 1, comprenant en outre les étapes consistant à :
déterminer une différence entre au moins une température de référence et la mesure de température du capteur de température ; et
valider le capteur de température selon que la différence dépasse ou non un seuil préconfiguré.

3. Procédé selon la revendication 1 ou 2, dans lequel la détermination de la résistance interne et de l'état de charge de l'au moins un élément de batterie et l'au moins une mesure de température du capteur de température sont réalisées pendant une période de temps préconfigurée.

4. Procédé selon l'une quelconque des revendications précédentes, dans lequel la résistance interne d'au moins un élément de batterie est déterminée sur la base d'une mesure d'une chute de tension pendant une impulsion de décharge.

5. Procédé selon la revendication 4, dans lequel la chute de tension est mesurée par rapport à une tension aux bornes réelle de l'au moins un élément de batterie et en réponse à un courant de charge ou d'équilibrage spécifique tiré de l'au moins un élément de batterie et/ou à un courant de recharge ou d'équilibrage spécifique fourni à l'au moins un élément de batterie.

6. Procédé selon l'une quelconque des revendications précédentes, dans lequel la résistance interne d'au moins un élément de batterie est déterminée en mesurant une tension transitoire en réponse à la coupure d'une charge spécifique de l'au moins un élément de batterie.

7. Procédé selon l'une quelconque des revendications précédentes, dans lequel le SOC de l'au moins un élément de batterie est déterminé sur la base de la mesure d'une tension aux bornes réelle de l'au moins un élément de batterie.

8. Procédé selon la revendication 7, dans lequel une valeur de SOC de référence est déterminée sur la base de la tension aux bornes réelle mesurée et d'une table de consultation de SOC, LUT.

9. Procédé selon l'une quelconque des revendications précédentes, dans lequel l'élément de batterie de référence est du même type que l'au moins un élément de batterie.

10. Système de batterie, comprenant au moins un élément de batterie, au moins un capteur de température en contact thermique avec l'au moins un élément de batterie, au moins un capteur de tension pour mesurer une tension aux bornes de l'au moins un élément de batterie, et une unité de commande configurée pour réaliser le procédé de l'une quelconque des revendications 1 à 9.

11. Système de batterie selon la revendication 10, comprenant en outre :
au moins un module de batterie avec une pluralité d'éléments de batterie alignés ;
au moins un capteur de température en contact thermique avec au moins un élément de batterie du module de batterie ;
au moins un capteur de tension configuré pour mesurer une tension aux bornes d'un élément de batterie du module de batterie ; et
au moins un capteur de courant configuré pour mesurer un courant de charge, d'équilibrage et/ou de recharge de l'élément de batterie du module de batterie ;
dans lequel l'unité de commande comprend au moins un circuit de supervision d'élément, CSC, connecté à l'un des au moins un modules de batterie et configuré pour recevoir des valeurs de mesure des capteurs du module de batterie connecté.

12. Système de batterie selon la revendication 11, dans lequel l'unité de commande comprend en outre un système de gestion de batterie, BMS, connecté à au moins un CSC, et est configurée pour :
recevoir des valeurs de tension, de courant et de température de l'au moins un CSC,
déterminer un SOC et une résistance interne d'au moins un élément de batterie du module de batterie connecté à l'au moins un CSC,
déterminer l'au moins une température de référence, et la comparer à l'au moins une valeur de température reçue de l'au moins un CSC.
